# EUROPEAN PATENT APPLICATION

(11) **EP 2 192 628 A2**
(43) Date of publication of application: **02.06.2010**
(21) Application number: 09165611.6
(22) Date of filing: 16.07.2009
(51) Int. Cl.: H01L 35/32, H01L 35/34

(54) **Thermoelectric Device, Thermoelectric Device Module, and Method of forming the Thermoelectric Device**

(30) Priority: 26.11.2008 KR 20080118110
(71) Applicant: Electronics and Telecommunications Research Institute, Daejeon 305-700 (KR)
(72) Inventor: JANG, Moon-Gyu, Jijok-dong, Yuseong-gu, Daejeon (KR); JUN, Myung-Sim, Daejeon (KR); ROH, Tae-Moon, Daejeon (KR); KIM, Jong-Dae, Yuseong-gu, Daejeon (KR); ZYUNG, Tae-Hyoung, Daejeon (KR)
(74) Representative: Betten & Resch

(57) **Abstract**

Provided are a thermoelectric device, a thermoelectric device module, and a method of forming the thermoelectric device. The thermoelectric device includes a first conductive type first semiconductor nanowire including at least one first barrier region; a second conductive type second semiconductor nanowire including at least one second barrier region; a first electrode connected to one end of the first semiconductor nanowire; a second electrode connected to one end of the second semiconductor nanowire; and a common electrode connected to the other end of the first semiconductor nanowire and the other end of the second semiconductor nanowire. The first barrier region is greater than the first semiconductor nanowire in thermal conductivity, and the second barrier region is greater than the second semiconductor nanowire in thermal conductivity.

## Description

### CROSS-REFERENCE TO RELATED APPLICATIONS

This patent application claims priority of Korean Patent Application No. 10-2008-0118110, filed on November 26, 2008, the entire contents of which are hereby incorporated by reference.

### BACKGROUND OF THE INVENTION

The present invention disclosed herein relates to a thermoelectric device, and more particularly, to a thermoelectric device including semiconductor nanowires.

The thermoelectric effect, discovered by Thomas Seebeck in 1821, has been widely applied to industries from the 1950s, together with discovering new semiconductor materials. Typically, materials generating the thermoelectric effect include Bi₂Te₃ that has a figure-of-merit (ZT) close to 1. However, heavy metals are used for the thermoelectric devices including Bi₂Te₃, and the thermoelectric devices including Bi₂Te₃ are very difficult to recycle. In addition, the thermoelectric devices including Bi₂Te₃ may cause environmental pollution. Furthermore, the thermoelectric devices including Bi₂Te₃ have a low mechanical strength, and are difficult to miniaturize and very susceptible to moisture damage.

### SUMMARY OF THE INVENTION

The present invention provides a thermoelectric device including semiconductor nanowires.

The present invention also provides a thermoelectric device module including semiconductor nanowires.

The present invention also provides a method of forming a thermoelectric device including semiconductor nanowires.

Embodiments of the present invention provide thermoelectric devices including: a first conductive type first semiconductor nanowire including at least one first barrier region; a second conductive type second semiconductor nanowire including at least one second barrier region; a first electrode connected to one end of the first semiconductor nanowires; a second electrode connected to one end of the second semiconductor nanowire; and a common electrode connected to the other end of the first semiconductor nanowire and the other end of the second semiconductor nanowire. The first barrier region is greater than the first semiconductor nanowire in thermal conductivity, and the second barrier region is greater than the second semiconductor nanowire in thermal conductivity.

In some embodiments, the first barrier region may be equal or greater than the first semiconductor nanowire in electric conductivity.

In some embodiments, the second barrier region may be equal or greater than the second semiconductor nanowire in electric conductivity.

In other embodiments, the first barrier region and the first semiconductor nanowire may form an ohmic contact, and the second barrier region and the second semiconductor nanowire may form an ohmic contact.

In still other embodiments, a first conductive type of the first semiconductor nanowire may be an N-type conductive type, and a second conductive type of the second semiconductor nanowire may be a P-type conductive type.

In even other embodiments, the first semiconductor nanowire and the second semiconductor nanowire may include at least one nf Si and Ge.

In yet other embodiments, the first barrier region or the second barrier region may include at least one of a Si-metal compound, a Ge-metal compound, and a Si-Ge-metal compound.

In further embodiments, a first conductive type of the first semiconductor nanowire may be an N-type conductive type, and a second conductive type of the second semiconductor nanowire may be a P-type conductive type, and the first barrier region may include erbium silicide, and the second barrier region may include platinum silicide.

In still further embodiments, the first electrode, the second electrode, and the common electrode may include at least one of a doped semiconductor, a metal, and a metal compound.

In even further embodiments, the common electrode may include a first common electrode and a second common electrode, and the first common electrode may include a material of the first electrode, and the second common electrode may include a material of the second electrode.

In yet further embodiments, the first electrode, the second electrode, and the common electrode may include at least one of a multi-layered structure including a semiconductor and a mctal-silicide, a multi-layered structure including a semiconductor and a metal compound, and a multi-layered structure including a semiconductor and a metal.

In much further embodiments, the first semiconductor nanowire and the first electrode may form an ohmic contact, and the second semiconductor nanowire and the second electrode may form an ohmic contact.

In still much further embodiments, the first semiconductor nanowire and the common electrode may form an ohmic contact, and the second semiconductor nanowire and the common electrode may form an ohmic contact.

In even much further embodiments, the thermoelectric devices may further include a support substrate, wherein the first nanowire and the second nanowire may extend in parallel with a plane of the support substrate.

In yet much further embodiments, the thermoelectric devices may further include a thermal insulating layer disposed between the support substrate and the first and second semiconductor nanowires.

In yet much further embodiments, the thermoelectric device may further include an optical absorber disposed on the common electrode.

In yet much further embodiments, the semiconductor nanowire and the second semiconductor nanowire may have a thickness or a width of about 100 nm or less.

In other embodiments of the present invention, thermoelectric device modules include: a plurality of thermoelectric devices arranged in a first direction and a second direction crossing the first direction in a matrix structure; first interconnection parts connecting the thermoelectric devices in series to constitute first groups; and second interconnection parts connecting the first groups in parallel. Each of the thermoelectric devices includes a first conductive type first semiconductor nanowire including at least one first barrier region, and a second conductive type second semiconductor nanowires including at least one second barrier region.

In still other embodiments of the present invention, methods of forming a thermoelectric device include: providing a support substrate; forming a first conductive type first semiconductor nanowire and a second conductive type second semiconductor nanowire on the support substrate, the nanowire being parallel with the support substrate; forming at least one first barrier region in the first semiconductor nanowire; forming at least one second barrier region in the second semiconductor nanowire; and forming a first electrode connected to one end of the first semiconductor nanowire, a second electrode connected to one end of the second semiconductor nanowire, and a common electrode connected to the other end of the first semiconductor nanowire and the other end of the second semiconductor nanowire. The first barrier region is greater than the first semiconductor nanowire in thermal conductivity, and the second barrier region is greater than the second semiconductor nanowire in thermal conductivity.

In some embodiments, the forming of the first and second semiconductor nanowires may include forming a sidewall spacer.

### BRIEF DESCRIPTION OF THE FIGURES

The accompanying figures are included to provide a further understanding of the present invention, and are incorporated in and constitute a part of this specification. The drawings illustrate exemplary embodiments of the present invention and, together with the description, serve to explain principles of the present invention. In the figures:

FIG. 1 is a perspective view illustrating a thermoelectric device according to an embodiment of the present invention;

FIGS. 2A through 2G are perspective views illustrating a method of forming a thermoelectric device according to an embodiment of the present invention;

FIG. 3 is a perspective view illustrating a thermoelectric device according to another embodiment of the present invention;

FIGS. 4A through 4G are perspective views illustrating a method of forming a thermoelectric device according to another embodiment of the present invention; and

FIG. 5 is a schematic view illustrating a thermoelectric device module according to an embodiment of the present invention.

### DETAILED DESCRIPTION OF PREFERRED EMBODIMENTS

Preferred embodiments of the present invention will be described below in more detail with reference to the accompanying drawings. The present invention may, however, be embodied in different forms and should not be constructed as limited to the embodiments set forth herein. Rather, these embodiments are provided so that this disclosure will be thorough and complete, and will fully convey the scope of the present invention to those skilled in the art.

In the figures, the dimensions of layers and regions are exaggerated for clarity of illustration. It will also be understood that when a layer is referred to as being 'on' another layer or substrate, it can be directly on the other layer or substrate, or intervening layers may also be present. Further, it will be understood that when a layer is referred to as being 'under' another layer, it can be directly under, and one or more intervening layers may also be present. In addition, it will also be understood that when a layer is referred to as being 'between' two layers, it can be the only layer between the two layers, or one or more intervening layers may also be present. Like reference numerals refer to like elements throughout.

Hereinafter, it will be described about an exemplary embodiment of the present invention in conjunction with the accompanying drawings.

A thermoelectric device according to an embodiment of the present invention includes semiconductor nanowires on a silicon substrate. Silicon has a thermal conductivity of about 150 W/mK that is a very high value. Since a thermoelectric device having the silicon, may have a ZT of about 0.01, it is difficult to apply the silicon to the thermoelectric device. However, silicon nanowires may have a ZT of about 1 or more.

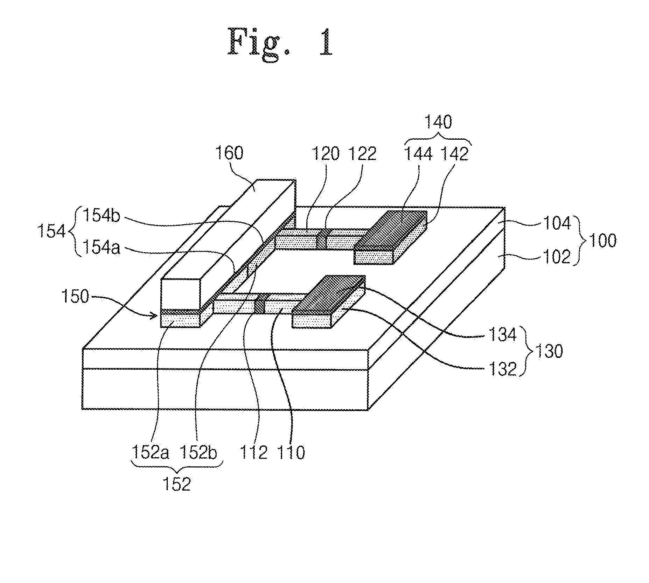

FIG. 1 is a perspective view illustrating a thermoelectric device according to one embodiment of the present invention.

Referring to FIG. 1, the thermoelectric device includes a first conductive-type first semiconductor nanowire 110 including at least one first barrier region 112, a second conductive-type second semiconductor nanowire 120 including at least one second barrier region 122, a first electrode 130 connected to one end of the first semiconductor nanowire 110, a second electrode 140 connected to one end of the second semiconductor nanowire 120, and a common electrode 150 connected to the other end of the first semiconductor nanowire 110 and the other end of the second semiconductor nanowire 120. The thermal conductivity of the first barrier region 112 may be greater than that of the first semiconductor nanowire 110. The thermal conductivity of the second barrier region 122 may be greater than that of the second semiconductor nanowire 120.

The thermoelectric device may include a support substrate 100 that may include at least one of a semiconductor substrate, a silicon on insulator (SOI) substrate, a glass substrate, a ceramic substrate, a plastic substrate, and an acrylic substrate. The first semiconductor nanowire 110 and the second semiconductor nanowire 120 may extend in parallel with a plane of the support substrate 100. The support substrate 100 may include a thermal insulating layer 104 that is disposed between the support substrate 100 and the first and second semiconductor nanowires 110 and 120.

The SOI substrate may have a structure including a semiconductor substrate 102, the thermal insulating layer 104, and a semiconductor layer (not shown). The semiconductor layer may have a thickness of about 50 nm or less. As the thickness of the semiconductor layer decreases, the thermal conductivity of the semiconductor layer may decrease. The semiconductor layer may be a silicon layer. For example, the thermal insulating layer 104 may be a silicon oxide layer. The thermal insulating layer 104 may have a thickness of about 200 nm or more. As the thickness of the thermal insulating layer 104 increases, the amount of heat transferred from a structure on the thermal insulating layer 104 to the semiconductor substrate 102 under the thermal insulating layer 104 may be decreased. The semiconductor layer may have at least one of a single crystal structure, a polycrystalline structure, and an amorphous structure. The thermal insulating layer 104 may have a low thermal conductivity and/or a low electric conductivity. The semiconductor layer or the semiconductor substrate 102 may be further provided with semiconductor devices driving the thermoelectric device.

The first conductive-type first semiconductor nanowires 110 including the first barrier region 112, and the second conductive-type second semiconductor nanowire 120 including the second barrier region 122 may be disposed on the support substrate 100. The first semiconductor nanowire 110 and/or the second semiconductor nanowire 120 may have a diameter or a width of about 100 nm or less. For example, the first semiconductor nanowire 110 and the second semiconductor nanowire 120 may have a diameter or a width of about 10 nm or less. The first semiconductor nanowire 110 and the second semiconductor nanowire 120 may include at least one of Si and Ge. The first conductive type may be an N-type conductive type, and the second conductive type may be a P-type conductive type. The first conductive type impurity concentration and the second conductive type impurity concentration may range from about 10¹⁷ cm⁻³ to about 10¹⁹ cm⁻³. The first semiconductor nanowire 110 and the second semiconductor nanowire 120 may have one of a polygonal cross-section, a circular cross-section, an oval cross-section, and fan-shaped cross-section. The first semiconductor nanowire 110 and the second semiconductor nanowire 220 may have a length of about 50 nm or more.

The first barrier region 112 and the second barrier region 122 may be thermal barrier. The first barrier region 112 may be less than the first semiconductor nanowire 110 in thermal conductivity. The second barrier region 122 may be less than the second semiconductor nanowire 120 in thermal conductivity. The electric conductivity of the first barrier region 112 may be equal or greater than that of the first semiconductor nanowire 110. the electric conductivity of the second barrier region 122 may be equal or greater than that of the second semiconductor nanowire 120. The first barrier region 112 and the first semiconductor nanowire 110 may form an ohmic contact. The second barrier region 122 and the second semiconductor nanowire 120 may form an ohmic contact. The first barrier region 112 or the second barrier region 122 may include at least one of a Si-metal compound, a Ge-metal compound, and a Si-Ge-metal compound. The first barrier region 112 may include at least one of erbium (Er), europium (Eu), samarium (Sm), magnesium (Mg), and a silicide thereof. The second barrier region 122 may include at least one of platinum (Pt), ytterbium (Yb), and a silicide thereof. For example, the first conductive type may be an N-type conductive type, and the second conductive type may be a P-type conductive type. In this case, the first barrier region 112 may include erbium silicide (ErSix), and the second barrier region 122 may include platinum silicide (PtSix). The erbium-silicide may provide a very low barrier height of a schottky junction for electrons. The erbium-silicide may electrically have an ohmic characteristic. Thus, the electric conductivity of the erbium-silicide may be substantially equal to that of the first semiconductor nanowire 110. The thermal conductivity of the erbium-silicide may be even less than that of the first semiconductor nanowire 110. The platinum-silicide may provide a very low barrier height of a schottky junction for electrons. The platinum-silicide may electrically have an ohmic characteristic. Thus, the electric conductivity of the platintum-silicide may be substantially equal to that of the second semiconductor nanowire 120. The thermal conductivity of the platinuin-silicide may be even less than that of the second semiconductor nanowire 120.

According to another embodiment of the present invention, each of the first barrier region 112 and the second barrier region 122 may be provided in plurality. The number of the first barrier regions 112 may be different from the number of the second barrier regions 122.

The first electrode 130, the second electrode 140, and the common electrode 150 may include at least one of a doped semiconductor, a metal, and a metal compound. The first electrode 130 may have a multi-layered structure of a first lower electrode 132 and a first upper electrode 134. The second electrode 140 may have a multi-layered structure of a second low electrode 142 and a second upper electrode 144. The first upper electrode 134 may include at least one of a metal, a metal compound, and a metal silicide. The first upper electrode 134 may include at least one of erbium (Er), europium (Eu), samarium (Sm), magnesium (Mg), and a silicide thereof. The second upper electrode 144 may include at least one of a metal, a metal compound, and a metal silicide. The second upper electrode 144 may include at least one of platinum (Pt), ytterbium (Yb), and a silicide thereof. The first lower electrode 132 may include the material of the first semiconductor nanowire 110. The second low electrode 142 may include the material of the second semiconductor nanowire 120. The first lower electrode 132 may be a first conductive type semiconductor. The second low electrode 142 may be a second conductive type semiconductor.

The first lower electrode 132 and the first semiconductor nanowire 110 may form an ohmic contact. The second low electrode 142 and the second semiconductor nanowire 120 may form an ohmic contact. The ohmic contacts may improve the movements of carriers, such as electrons or holes, due to the temperature difference between the first and second semiconductor nanowires 110 and 120.

The common electrode 150 may include a lower common electrode 152 and an upper common electrode 154. The lower common electrode 152 may include a first lower common electrode 152a and a second lower common electrode 152b. The upper common electrode 154 may include a first upper common electrode 154a and a second upper common electrode 154b.

The common electrode 150 may include at least one of a doped semiconductor, a metal, and a metal compound. The common electrode 150 may have at least one of a multi-layered structure including a semiconductor and a metal-silicide, a multi-layered structure including a semiconductor and a metal compound, and a multi-layered structure including a semiconductor and a metal. The first semiconductor nanowire 110 and the common electrode 150 may form an ohmic contact. The second semiconductor nanowire 120 and the common electrode 150 may form an ohmic contact. The area of the common electrode 150 may be greater than the area of the first and second electrodes 130 and 140.

For example, the first lower common electrode 152a may be a first conductive type semiconductor, and the first upper common electrode 154a may be a metal silicide. The second lower common electrode 152b may be a second conductive type semiconductor, and the second upper common electrode 154b may be a metal silicide. The first upper common electrode 154a may include at least one of erbium (Er), europium (Eu), samarium (Sm); magnesium (Mg), and a silicide thereof. The second upper common electrode 154b may include at least one of platinum (Pt), ytterbium (Yb), and a silicide thereof.

An optical absorber 160 may be disposed on the common electrode 150. The optical absorber 160 may be a member for absorbing solar energy and converting the solar energy into thermal energy. The optical absorber 160 may includes a titanium oxide (TiO) layer. The optical absorber 160 may apply a temperature difference between the first semiconductor nanowire 110 and the second semiconductor nanowire 120.

According to another embodiment of the present invention, the common electrode 150 may be in direct or indirect contact with a heat source.

According to another embodiment of the present invention, an intrinsic semiconductor structure (not shown) may be disposed between the first electrode 130 and the second electrode 140. The intrinsic semiconductor structure may electrically separate the first electrode 130 and the second electrode 140 from each other.

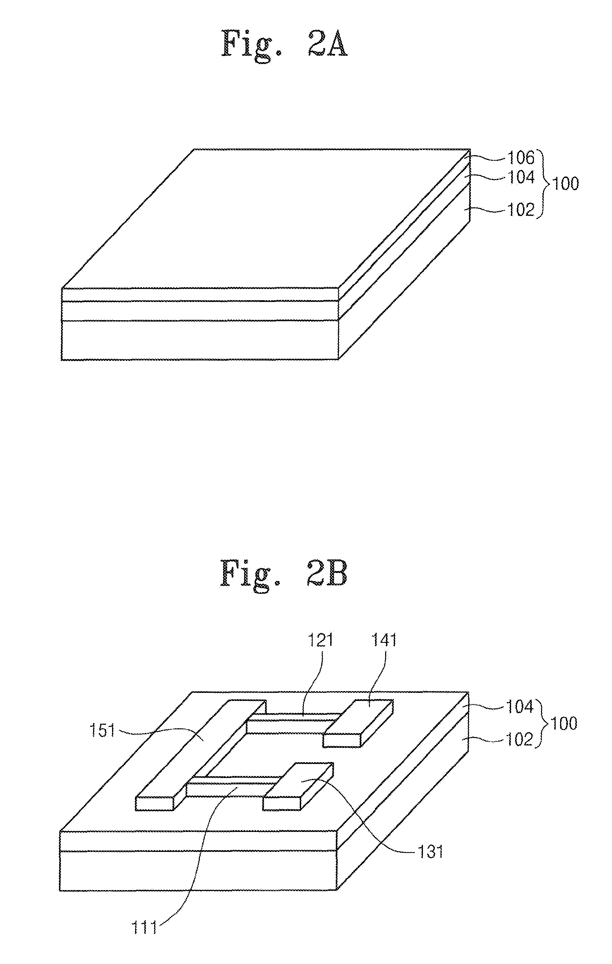

FIGS. 2A through 2E are perspective views illustrating a method of forming a thermoelectric device according to an embodiment of the present invention.

Referring to FIG. 2A, the support substrate 100 may be a SOI substrate. The support substrate 100 may include the semiconductor substrate 102, the thermal insulating layer 104, and a semiconductor layer 106. The semiconductor layer 106 may have a thickness of about 50 nm or less. As the thickness of the semiconductor layer 106 decreases, the thermal conductivity or heat transfer performance of the semiconductor layer 106 may decrease. The semiconductor layer 106 may be a silicon layer. The thermal insulating layer 104 may have a low thermal conductivity and/or a low electric conductivity. For example, the thermal insulating layer 104 may be a silicon oxide layer. The thermal insulating layer 104 may have a thickness of about 200 nm or more. As the thickness of the thermal insulating layer 104 increases, the amount of heat transferred from a structure on the thermal insulating layer 104 to the semiconductor substrate 102 under the thermal insulating layer 104 may be decreased. The semiconductor layer 106 may have at least one of a single crystal structure, a polycrystalline structure, and an amorphous structure.

Referring to FIG. 2B, the semiconductor layer 106 may be patterned to form a first preliminary semiconductor nanowire 111, a second preliminary semiconductor nanowire 121, a first preliminary lower electrode 131, a second preliminary lower electrode 141, and a preliminary lower common electrode 151. The patterning may be performed using an electron beam lithography method, a sidewall forming method, and a typical exposure method. One end of the first preliminary semiconductor nanowire 111 may be connected to the first preliminary lower electrode 131, and one end of the second preliminary semiconductor nanowire 121 may be connected to the second preliminary lower electrode 141. The other end of the first preliminary semiconductor nanowire 111 and the other end of the second preliminary semiconductor nanowire 121 may be connected to the preliminary lower common electrode 151.

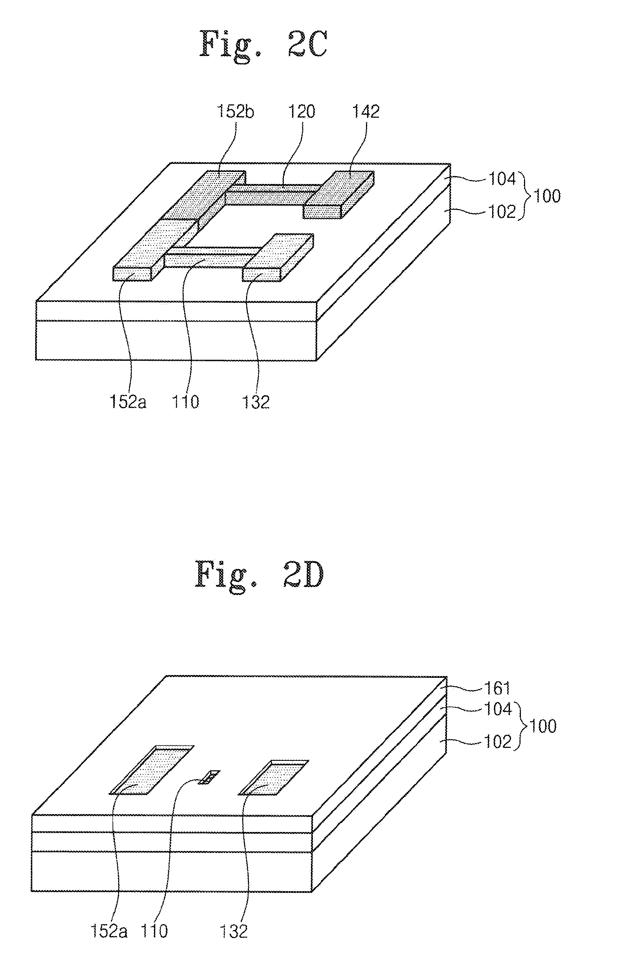

Referring to FIG. 2C, an impurity implantation process may be performed on the support substrate 100. The impurity implantation process may include an ion implantation process using at least one of an ion beam, a diffusion process, and plasma. Accordingly, the first preliminary semiconductor nanowire 111 may be doped with first conductive type impurities to form the first semiconductor nanowire 110.

The second preliminary semiconductor nanowire 121 may be doped with second conductive type impurities to form the second semiconductor nanowire 120. The first preliminary lower electrode 131 and the first preliminary semiconductor nanowire 111 may be simultaneously doped to form the first lower electrode 132. The second preliminary lower electrode 141 and the second preliminary semiconductor nanowire 121 may be simultaneously doped to form the second lower electrode 142. A portion of the preliminary lower common electrode 151, contacting the first preliminary semiconductor nanowire 111. may be doped with the first conductive type impurities to form the first lower common electrode 152a. A portion of the preliminary lower common electrode 151, contacting the second preliminary semiconductor nanowire 121, may be doped with the second conductive type impurities to form the second lower common electrode 152b. The first conductive type may be an N-type conductive type, and the second conductive type may be a P-type conductive type. A first conductive type impurity concentration and a second conductive type impurity concentration may range from about 10¹⁷ cm⁻³ to about 10¹⁹ cm⁻³.

Referring to FIG. 2D, a first interlayer dielectric 161 may be deposited on the support substrate 100. The first interlayer dielectric 161 is patterned to partially expose the first lower electrode 132, the first lower common electrode 152a, and the first semiconductor nanowire 110.

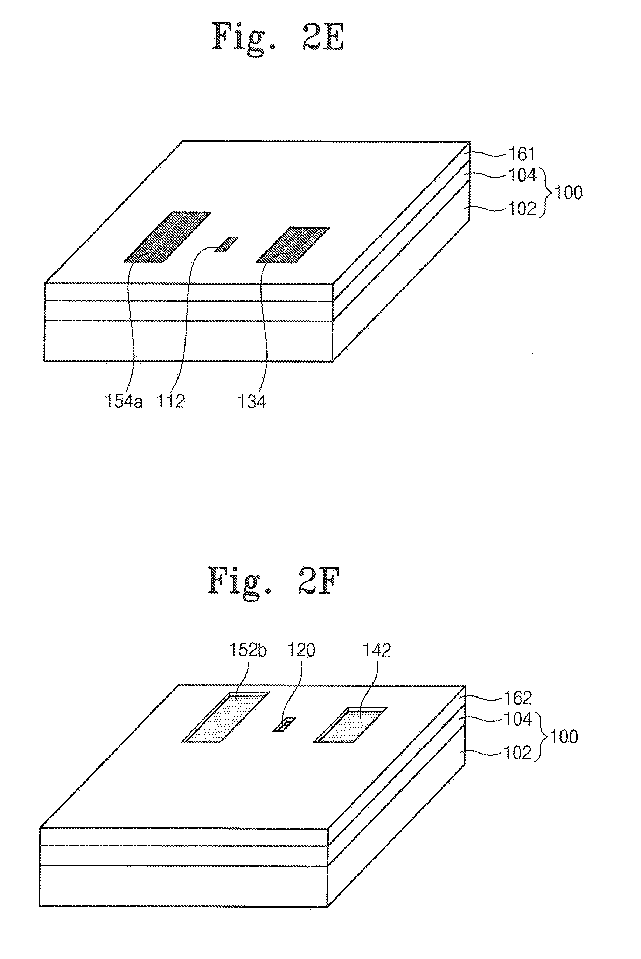

Referring to FIG. 2E, metal may be deposited in exposed portions on the support substrate 100. The metal may include at least one of erbium (Er), europium (Eu), samarium (Sm), and magnesium (Mg).

The depositing of the metal may be performed using at least one of a chemical vapor deposition method, a sputtering method, and an evaporation method. Then, the support substrate 100 with the metal may be heat-treated to form a metal silicide. The metal silicide may provide the first barrier region 112, the first upper electrode 134, and the first upper common electrode 154a. Then, a portion without the metal silicide may be removed through a selective etching process.

Referring to FIG. 2F, the first interlayer dielectric 161 may be removed from the support substrate 100, and then a second interlayer dielectric 162 may be formed on the support substrate 100. The second interlayer dielectric 162 may be patterned to partially expose the second low electrode 142, the second lower common electrode 152b. and the second semiconductor nanowire 120.

According to another embodiment of the present invention, the first interlayer dielectric 161 may be patterned to partially expose the second low electrode 142, the second lower common electrode 152b, and the second semiconductor nanowire 120, without removing the first interlayer dielectric 161.

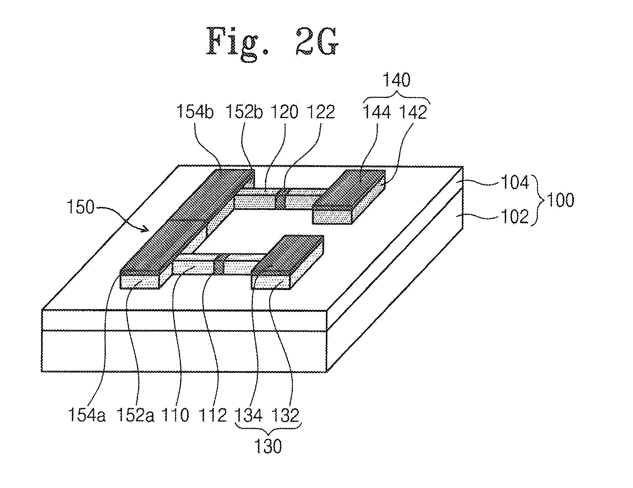

Referring to FIG. 2G, metal may be deposited in exposed portions on the support substrate 100. The metal may be platinum (Pt) or ytterbium (Yb). The depositing of the metal may be performed using at least one of the chemical vapor deposition method, the sputtering method, and the evaporation method. Then, the support substrate 100 with the metal may be heat-treated to form a metal silicide. The metal silicide may provide the second barrier region 122, the second upper electrode 144, and the second upper common electrode 154b. Then, a portion without the metal silicide may be removed through a selective etching process. The second interlayer dielectric 162 may be removed.

Referring again to FIG. 1, an optical absorber layer (not shown) may be formed on the support substrate 100. The optical absorber layer may be patterned to form the optical absorber 160 on the common electrode 150. The optical absorber layer may include a titanium oxide layer.

According to another embodiment of the present invention, the first and second lower electrodes 132 and 142, and the first and second lower common electrodes 152a and 152b may be formed on the support substrate 100, as illustrated in FIG. 2C. A first metal may be deposited and patterned on the support substrate 100. Then, the support substrate 100 may be heat-treated to form a metal silicide. The first metal may be selectively etched to form the first barrier region 112, the first upper electrode 134, and the first upper common electrode 154a. The first metal may include at least one of erbium (Er), europium (Eu), samarium (Sm), and magnesium (Mg). A second metal may be deposited and patterned on the support substrate 100. Then, the second metal may be heat-treated to form a second metal silicide. Then, the second metal on the support substrate 100 may be selectively etched to form the second barrier region 122, the second upper electrode 144, and the second upper common electrode 154b. The second metal may be platinum (Pt) or ytterbium (Yb).

According to another embodiment of the present invention, the first and second lower electrodes 132 and 142, and the first and second lower common electrodes 152a and 152b may be formed on the support substrate 100, as illustrated in FIG. 2C. A photoresist pattern, having a negative slope, is formed on the support substrate 100, and a first metal is deposited on the photoresist pattern and patterned through a lift-off process. Then, the support substrate 100 may be heat-treated to form a first metal silicide. The first metal silicide may provide the first barrier region 112, the first upper electrode 134, and the first upper common electrode 154a. The first metal may include at least one of erbium (Er), europium (Eu), samarium (Sm), and magnesium (Mg).

A photoresist pattern, having a negative slope, is formed on the support substrate 100, and a second metal is deposited on the photoresist pattern and patterned through a lift-off process. Then, the second metal may be heat-treated to form a second metal silicide. The second metal silicide may provide the second barrier region 122, the second upper electrode 144, and the second upper common electrode 154b. The second metal may be platinum (Pt) or ytterbium (Yb).

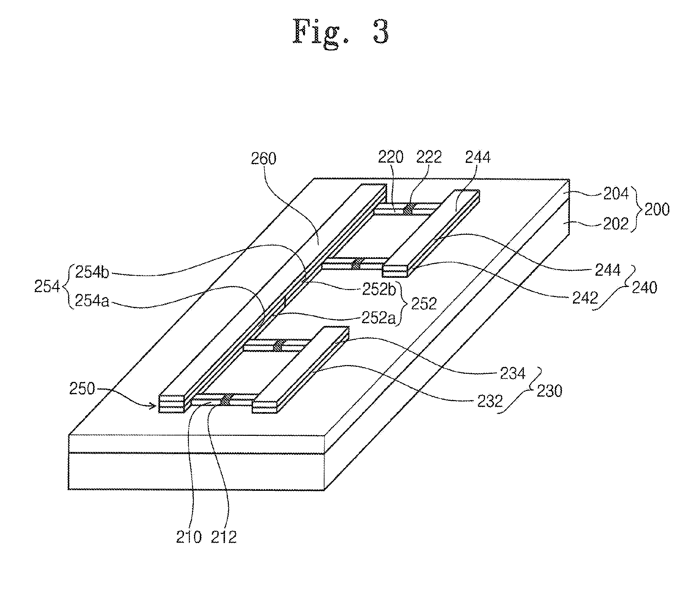

FIG. 3 is a perspective view illustrating a thermoelectric device according to another embodiment of the present invention.

Referring to FIG. 3, the thermoelectric device includes a first conductive-type first semiconductor nanowire 210 including at least one first barrier regions 212, a second conductive-type second semiconductor nanowire 220 including at least one second barrier region 222, a first electrode 230 connected to one end of the first semiconductor nanowire 210, a second electrode 240 connected to one end of the second semiconductor nanowire 220, and a common electrode 250 connected to the other end of the first semiconductor nanowire 210 and the other end of the second semiconductor nanowire 220. The thermal conductivity of the first barrier region 212 may be greater than that of the first semiconductor nanowire 210. The thermal conductivity of the second barrier region 222 may be greater than that of the second semiconductor nanowire 220.

The thermoelectric device may include a support substrate 200 that may include at least one of a semiconductor substrate, a silicon on insulator (SOI) substrate, a glass substrate, a ceramic substrate, a plastic substrate, and an acrylic substrate. The first semiconductor nanowire 210 and the second semiconductor nanowire 220 may extend in parallel with a plane of the support substrate 200. The first semiconductor nanowire 210 may be provided in plurality, and the second second semiconductor nanowire 220 may be provided in plurality. The support substrate 200 may include a thermal insulating layer 204 that is disposed between the support substrate 200 and the first and second semiconductor nanowires 210 and 220.

In the case of the SOI substrate, the support substrate 200 may have a structure including a semiconductor substrate 202, the thermal insulating layer 204, and a semiconductor layer (not shown). The semiconductor layer may have a thickness of about 50 nm or less. As the thickness of the semiconductor layer decreases, the thermal conductivity of the semiconductor layer may decrease. The semiconductor layer may be a silicon layer. The thermal insulating layer 204 may be a silicon oxide layer. The thermal insulating layer 204 may have a thickness of about 200 nm or more. As the thickness of the thermal insulating layer 204 increases, the amount of heat transferred from a structure on the thermal insulating layer 204 to the semiconductor substrate 202 under the thermal insulating layer 204 may be decreased. The semiconductor layer may have at least one of a single crystal structure, a polycrystalline structure, and an amorphous structure. The thermal insulating layer 204 may have a low thermal conductivity and/or a low electric conductivity. The semiconductor layer or the semiconductor substrate 202 may be provided with semiconductor devices driving the thermoelectric device.

The first conductive-type first semiconductor nanowire 210 including the first barrier region 212, and the second conductive-type second semiconductor nanowire 220 including the second barrier region 222 may be disposed on the support substrate 200. The first semiconductor nanowire 210 and/or the second semiconductor nanowire 220 may have a diameter or a width of about 100 nm or less. For example, the first semiconductor nanowire 210 and the second semiconductor nanowire 220 may have a diameter or a width of about 10 nm or less. The first semiconductor nanowire 210 and the second semiconductor nanowire 220 may include at least one of Si and Ge. The first conductive type may be an N-type conductive type, and the second conductive type may be a P-type conductive type. A first conductive type impurity concentration and a second conductive type impurity concentration may range from about 10¹⁷ cm⁻³ to about 10¹⁹ cm⁻³. The first semiconductor nanowire 210 and the second semiconductor nanowire 220 may have one of a polygonal cross-section, a circular cross-section, an oval cross-section, and fan-shaped cross-section. The first semiconductor nanowire 210 and the second semiconductor nanowire 220 may have a length of about 50 nm or more.

The first barrier region 212 and the second barrier region 222 may be thermal barriers. The first barrier region 212 may be less than the first semiconductor nanowire 210 in thermal conductivity. The second barrier region 222 may be less than the second semiconductor nanowire 220 in thermal conductivity. The electric conductivity of the first barrier region 212 may be equal or greater than that of the first semiconductor nanowire 210. The electric conductivity of the second barrier region 222 may be equal or greater than that of the second semiconductor nanowire 220. The first barrier region 212 and the first semiconductor nanowire 210 may form an ohmic contact. The second barrier region 222 and the second semiconductor nanowire 220 may form an ohmic contact. The first barrier region 212 or the second barrier region 222 may include at least one of a Si-metal compound, a Ge-metal compound, and a Si-Ge-metal compound. The first barrier region 212 may include at least one of erbium (Er), europium (Eu), samarium (Sm), magnesium (Mg), and a silicide thereof. The second barrier region 222 may include at least one of platinum (Pt), ytterbium (Yb), and a silicide thereof. For example, the first conductive type may be an N-type conductive type, and the second conductive type may be a P-type conductive type. In this case, the first barrier region 212 may include erbium silicide (ErSix), and the second barrier region 222 may include platinum silicide (PtSix). The erbium-silicide may provide a very low barrier height of a schottky junction for electrons. The erbium-silicide may electrically have an ohmic characteristic. Thus, the electric conductivity of the erbium-silicide may be substantially equal to that of the first semiconductor nanowire 210. The thermal conductivity of the erbium-silicide may be even less than that of the first semiconductor nanowire 210. The platinum-silicide may provide a very low barrier height of a schottky junction for electrons. The platinum-silicide may electrically have an ohmic characteristic. Thus, the electric conductivity of the platinum-silicide may be substantially equal to that of the second semiconductor nanowire 220. The thermal conductivity of the platinum-silicide may be even less than that of the second semiconductor nanowire 220.

The first electrode 230, the second electrode 240, and the common electrode 250 may include at least one of a doped semiconductor, a metal, and a metal compound. The first electrode 230 may have a multi-layered structure including a first lower electrode 232 and a first upper electrode 234. The second electrode 240 may have a multi-layered structure including a second low electrode 242 and a second upper electrode 244. The first upper electrode 234 may include at least one of a metal, a metal compound, and a metal silicide. The first upper electrode 234 may include at least one of erbium (Er), europium (Eu), samarium (Sm), magnesium (Mg), and a silicide thereof. The second upper electrode 244 may include at least one of a metal, a metal compound, and a metal silicide. The second upper electrode 244 may include at least one of platinum (Pt), ytterbium (Yb), and a silicide thereof. The first lower electrode 232 may include the material of the first semiconductor nanowire 210. The second low electrode 242 may include the material of the second semiconductor nanowire 220. The first lower electrode 232 may be a first conductive type semiconductor. The second low electrode 242 may be a second conductive type semiconductor.

The first lower electrode 232 and the first semiconductor nanowire 210 may form an ohmic contact. The second low electrode 242 and the second semiconductor nanowire 220 may form an ohmic contact. The ohmic contacts may improve the movements of carriers, such as electrons or holes, due to the temperature difference between the first semiconductor nanowire 210 and the second semiconductor nanowire 220.

The common electrode 250 may include a lower common electrode 252 and an upper common electrode 254. The lower common electrode 252 may include a first lower common electrode 252a and a second lower common electrode 252b. The upper common electrode 254 may include a first upper common electrode 254a and a second upper common electrode 254b. The first lower common electrode 252a may include the material of the first lower electrode 232. The second lower common electrode 252b may include the material of the second lower electrode 242.

The common electrode 250 may include at least one of a doped semiconductor, a metal, and a metal compound. The common electrode 250 may have at least one of a multi-layered structure including a semiconductor and a metal-silicide, a multi-layered structure including a semiconductor and a metal compound, and a multi-layered structure including a semiconductor and a metal. The first semiconductor nanowire 210 and the common electrode 250 may form an ohmic contact. The second semiconductor nanowire 220 and the common electrode 250 may form an ohmic contact.

For example, the first lower common electrode 252a may be a first conductive type semiconductor, and the first upper common electrode 254a may be a metal silicide. The second lower common electrode 252b may be a second conductive type semiconductor, and the second upper common electrode 254b may be a metal silicide. The first upper common electrode 254a may include at least one of erbium (Er), europium (Eu), samarium (Sm), magnesium (Mg), and a silicide thereof. The second upper common electrode 254b may include at least one of platinum (Pt), ytterbium (Yb), and a silicide thereof.

An optical absorber 260 may be disposed on the common electrode 250. The optical absorber 260 may be a member for absorbing solar energy and converting the solar energy into thermal energy. The optical absorber 260 may include a titanium oxide (TiO) layer. The optical absorber 260 may cause the temperature difference between the first semiconductor nanowire 210 and the second semiconductor nanowire 220.

According to another embodiment of the present invention, the common electrode 250 may be in direct or indirect contact with a heat source.

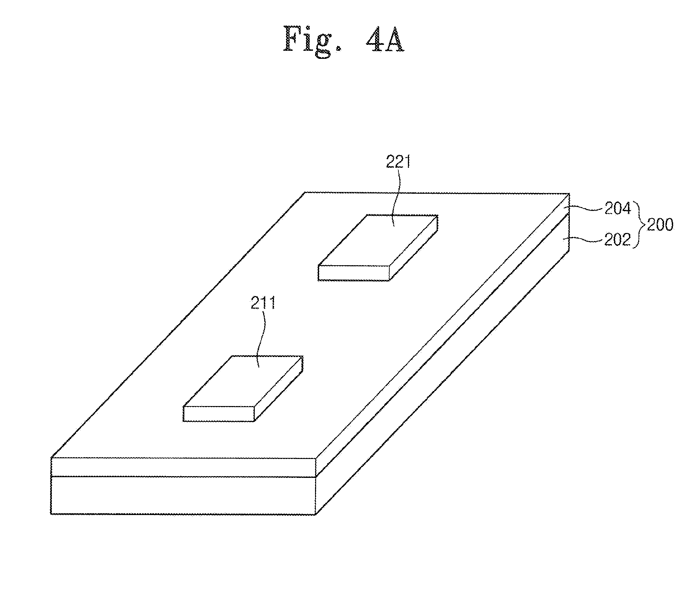

FIG. 4A through 4G are perspective views illustrating a method of forming a thermoelectric device according to another embodiment of the present invention.

Referring to FIG. 4A, the support substrate 200 may include the semiconductor substrate 202 and the thermal insulating layer 204. The thermal insulating layer 204 may be a silicon oxide layer. A dummy pad layer (not shown) may be formed on the thermal insulating layer 204. The dummy pad layer may be patterned to form dummy pads 211 and 221. The dummy pad layer may have an etch selectivity with respect to the thermal insulating layer 204. When the thermal insulating layer 204 is a silicon oxide layer, the dummy pad layer may be a silicon nitride layer.

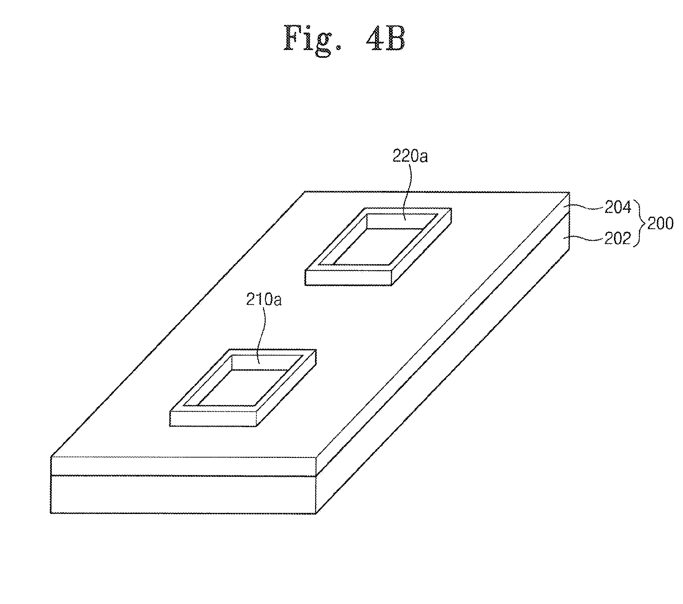

Referring to FIG. 4B, a semiconductor layer may be formed to conform with the support substrate 200. The semiconductor layer may be anisotropically etched to form sidewall spacers on sidewalls of the dummy pads 211 and 221. Then, the dummy pads 211 and 221 may be removed to form a first preliminary semiconductor nanowire 210a and a second preliminary semiconductor nanowire 220a. The first and second preliminary semiconductor nanowires 210a and 220a may have a closed band structure. Then, the first preliminary semiconductor nanowire 210a may be doped with first conductive type impurities by using a photoresist pattern process and an ion implantation process. Then, the second preliminary semiconductor nanowire 220a may be doped with second conductive type impurities by using a photoresist pattern process and an ion implantation process.

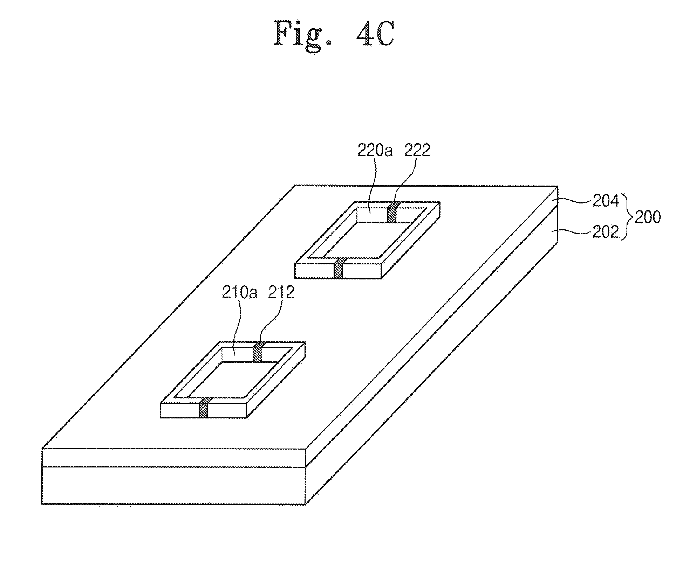

Referring to FIG. 4C, a first interlayer dielectric (not shown) may be deposited on the support substrate 200. The first interlayer dielectric is patterned to partially expose the first preliminary semiconductor nanowire 210a. Metal may be deposited in an exposed portion of the first preliminary semiconductor nanowire 210a on the support substrate 200. The metal may include at least one of erbium (Er), europium (Eu), samarium (Sm), and magnesium (Mg). The support substrate 200 may be heat-treated to form a metal silicide on the exposed portion of the first preliminary semiconductor nanowire 210a, The metal silicide may provide the first barrier region 212. Then, the metal may be removed through a selective etching process.

Then, the first interlayer dielectric may be removed, and a second interlayer dielectric (not shown) may be formed. The second interlayer dielectric may be patterned to partially expose the second preliminary semiconductor nanowire 220a. Metal may be deposited in an exposed portion of the second preliminary semiconductor nanowire 220a on the support substrate 200. The metal may include at least one of platinum (Pt) and ytterbium (Yb). Then, the support substrate 200 may be heat-treated to form a metal silicide on the exposed portion of the second preliminary semiconductor nanowire 220a. The metal silicide may provide the second barrier region 222. Then, the metal may be removed through a selective etching process. Then, the second interlayer dielectric may be removed through a selective etching process.

According to another embodiment of the present invention, a first metal may be deposited on the support substrate 200. The first metal may be patterned to cross the first preliminary semiconductor nanowire 210a. Then, the first metal may be heat-treated to form a metal silicide. Then, the first metal is removed from the support substrate 200 to form the first barrier region 212. Then, a second metal may be deposited on the support substrate 200. The second metal may be patterned to cross the second preliminary semiconductor nanowire 220a. Then, the second metal may be heat-treated to form a metal silicide. Then, the second metal is removed from the support substrate 200 to form the second barrier region 222.

According to another embodiment of the present invention, the first barrier region 212 and the second barrier region 222 may be formed using a lift-off lithography method.

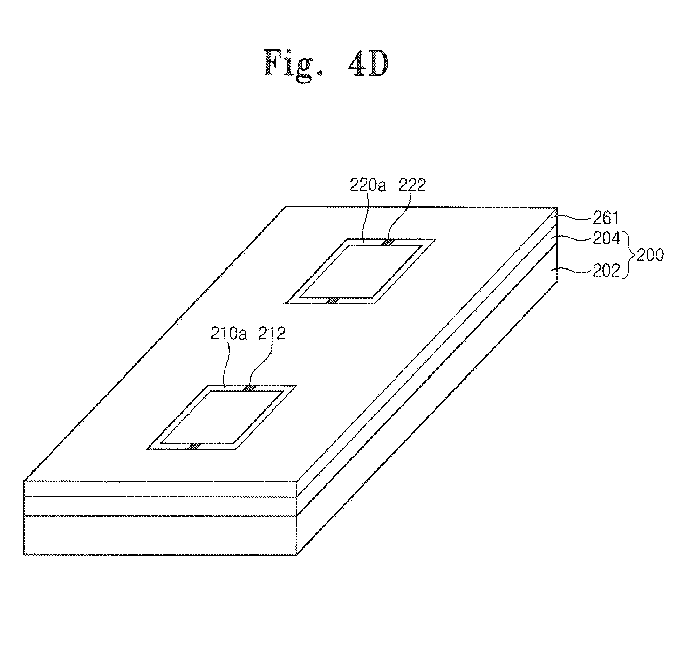

Referring to FIG. 4D, a third interlayer dielectric 261 may be formed on the support substrate 200. The top surface of the third interlayer dielectric 261 may be planarized. The planarizing of the top surface may be performed using an etch back process or a chemical mechanical polishing process.

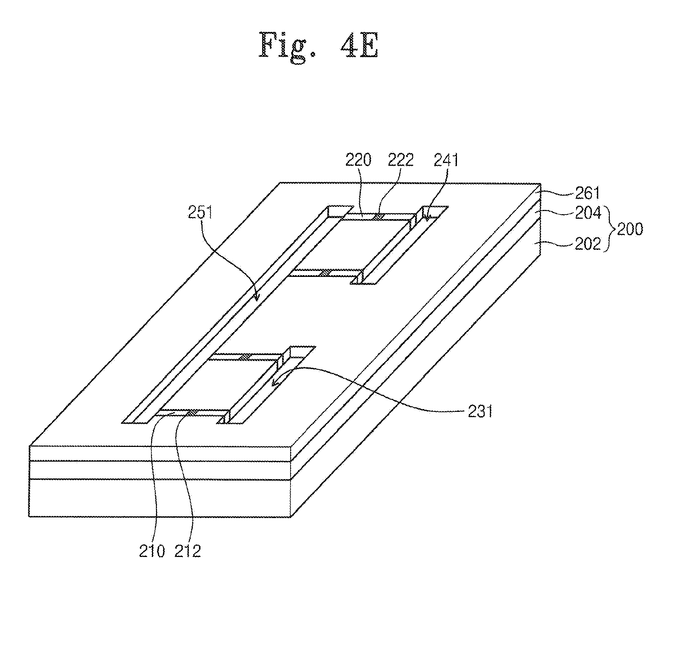

Referring to FIG. 4E, the third interlayer dielectric 261 and the first and second preliminary semiconductor nanowires 210a and 220a may be patterned to form a first lower electrode contact hole 231, a second lower electrode contact hole 241, and a lower common electrode contact hole 251. The first lower electrode contact hole 231 may be formed by partially removing the first preliminary semiconductor nanowire 210a. The first lower electrode contact hole 231 may be formed by etching the third interlayer dielectric 261, so as to expose the thermal insulating layer 204. The second lower electrode contact hole 241 may be formed by partially removing the second preliminary semiconductor nanowire 220a. The second lower electrode contact hole 241 may be formed by etching the third interlayer dielectric 261, so as to expose the thermal insulating layer 204. The lower common electrode contact hole 251 may be formed by partially removing the first and second preliminary semiconductor nanowires 210a and 220a. The lower common electrode contact hole 251 may be formed by etching the third interlayer dielectric 261, so as to expose the thermal insulating layer 204. The lower common electrode contact hole 251 may face the first and second lower electrode contact holes 231 and 241. The first semiconductor nanowire 210 may be formed by dividing the first preliminary semiconductor nanowire 210a. The second semiconductor nanowire 220 may be formed by dividing the second preliminary semiconductor nanowire 220a.

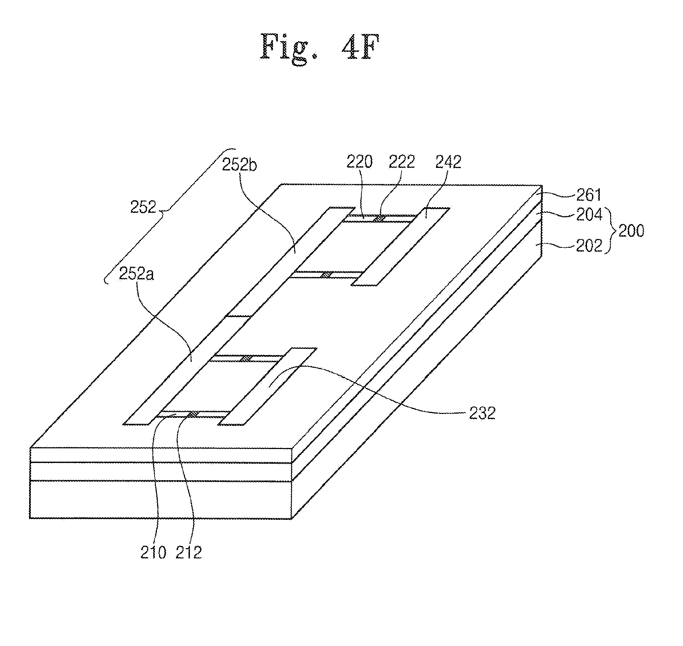

Referring to FIG. 4F, a semiconductor layer (not shown), filling the first lower electrode contact hole 231, the second lower electrode contact hole 241, and the lower common electrode contact hole 251, may be formed. The support substrate 200 provided with the semiconductor layer may be planarized to expose the third interlayer dielectric 261. A preliminary lower common electrode (not shown), a first preliminary lower electrode (not shown), and a second preliminary lower electrode (not shown) may be formed through the planarizing. The first lower electrode contact hole 231 may be filled with the first preliminary lower electrode. The second lower electrode contact hole 241 may be filled with the second preliminary lower electrode. The lower common electrode contact hole 251 may be filled with the preliminary lower common electrode.

An impurity implantation process may be performed on the support substrate 200. The impurity implantation process may include an implantation process using at least one of an ion beam, a diffusion process, and plasma. Accordingly, the first preliminary lower electrode may be doped with first conductive type impurities to form the first lower electrode 232. The second preliminary lower electrode may be doped with second conductive type impurities to form the second lower electrode 242. The first preliminary lower electrode and one portion of the preliminary lower common electrode may be simultaneously doped with the first conductive type impurities to form the first lower common electrode 252a. The second preliminary lower electrode and the other portion of the preliminary lower common electrode may be simultaneously doped with the second conductive type impurities to form the second lower common electrode 252b. The lower common electrode 252 may include the first lower common electrode 252a doped with the first conductive type impurities, and the second lower common electrode 252b doped with the second conductive type impurities. The first conductive type may be an N-type conductive type, and the second conductive type may be a P-type conductive type. A first conductive type impurity concentration and a second conductive type impurity concentration may range from about 10¹⁷ cm⁻³ to about 10¹⁹ cm⁻³.

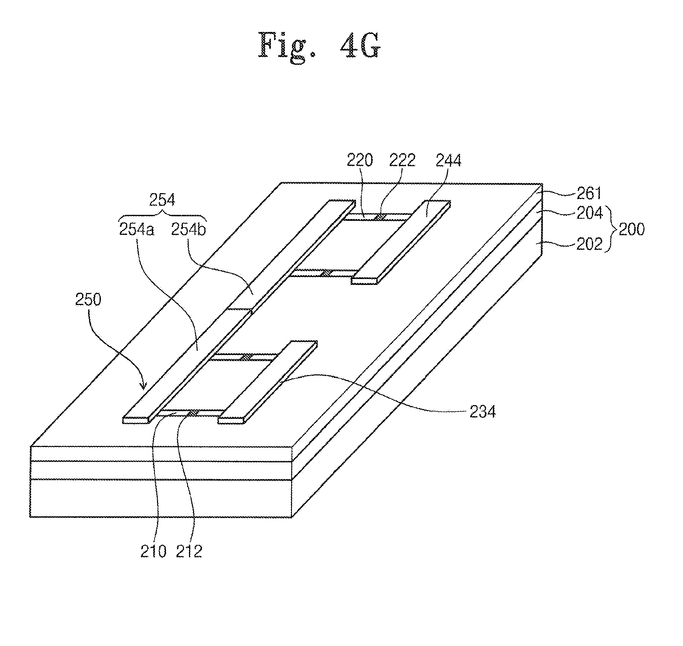

Referring to FIG. 4G, a first metal may be deposited on the support substrate 200. The first metal may include at least one of erbium (Er), europium (Eu), samarium (Sm), and magnesium (Mg). The depositing of the first metal may be performed using at least one of the chemical vapor deposition method, the sputtering method, and the evaporation method. The first metal may be patterned to be disposed on the first lower electrode 232 and the first lower common electrode 252a. Then, the support substrate 100 with the first metal may be heat-treated to form a first metal silicide. The first metal silicide may provide the first upper electrode 234 and the first upper common electrode 254a. Then, the first metal without the first metal silicide may be removed through a selective etching process.

A second metal may be deposited on the support substrate 200. The second metal may include at least one of platinum (Pt) and ytterbium (Yb). The depositing of the second metal may be performed using at least one of the chemical vapor deposition method, the sputtering method, and the evaporation method. The second metal may be patterned to be disposed on the second lower electrode 242 and the second lower common electrode 252b. Then, the support substrate 100 with the second metal may be heat-treated to form a second metal silicide. The second metal silicide may provide the second upper electrode 244 and the second upper common electrode 254b. Then, the second metal without the second metal silicide may be removed through a selective etching process. The first upper common electrode 254a and the second upper common electrode 254b may contact each other.

According to another embodiment of the present invention, the first upper electrode 234, the second upper electrode 244, and the upper common electrode 254 may be formed using a lift-off lithography process.

Referring again to FIG. 3, the optical absorber 260 may be disposed on the first upper common electrode 254a and the second upper common electrode 254b.

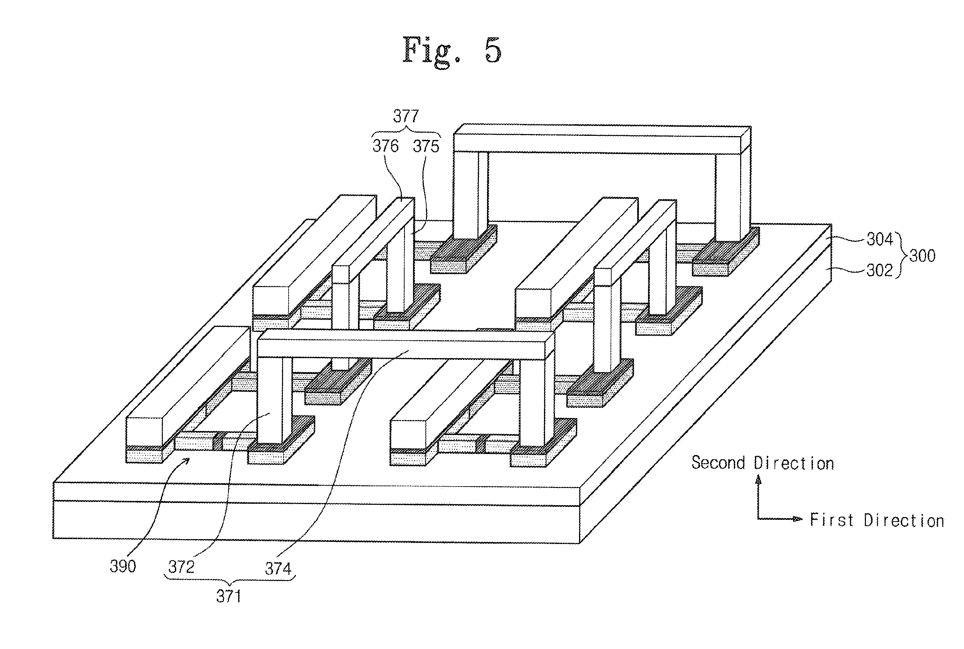

FIG. 5 is a schematic view illustrating a thermoelectric device module according to an embodiment of the present invention.

Thermoelectric devices 390 may be arranged in a first direction and a second direction crossing the first direction in a matrix structure. The thermoelectric device module may include first interconnection parts 377 that connect the thermoelectric devices 390 in series to constitute first groups. The first interconnection part 377 may include a first contact plug 375 and a first interconnection 376. The thermoelectric device module may include second interconnection parts 371 connecting the first groups in parallel. The second interconnection part 371 may include a second contact plug 372 and a second interconnection 374. Each of the thermoelectric devices 390 may include a first conductive type first semiconductor nanowire including at least one first barrier region, and a second conductive type second semiconductor nanowire including at least one second barrier region. The thermoelectric devices 390 are connected to each other in series through the first contact plug 375 and the first interconnection 376 to increase a voltage. The thermoelectric devices 390, connected in series, may be connected to each other in parallel through the second contact plug 372 and the second interconnection 374 to increase an electric current.

The thermoelectric device according to one embodiment of the present invention may have a ZT of about 1 or more, and be formed in a multi-layered structure on the plane of the substrate. Accordingly, typical processes for semiconductor and flat panel display devices can be used for the thermoelectric device, thereby reducing costs but improving mass production efficiency.

The above-disclosed subject matter is to be considered illustrative, and not restrictive, and the appended claims are intended to cover all such modifications, enhancements, and other embodiments, which fall within the true spirit and scope of the present invention. Thus, to the maximum extent allowed by law, the scope of the present invention is to be determined by the broadest permissible interpretation of the following claims and their equivalents, and shall not be restricted or limited by the foregoing detailed description.

## Claims

1. A thermoelectric device comprising:
a first conductive type first semiconductor nanowire including at least one first barrier region;
a second conductive type second semiconductor nanowire including at least one second barrier region;
a first electrode connected to one end of the first semiconductor nanowire;
a second electrode connected to one end of the second semiconductor nanowire; and
a common electrode connected to the other end of the first semiconductor nanowire and the other end of the second semiconductor nanowire,
wherein the first barrier region is greater than the first semiconductor nanowire in thermal conductivity, and the second barrier region is greater than the second semiconductor nanowire in thermal conductivity.

2. The thermoelectric device of claim 1, wherein the first barrier region is equal or greater than the first semiconductor nanowire in electric conductivity.

3. The thermoelectric device of any of the preceding claims, wherein the second barrier region is equal or greater than the second semiconductor nanowire in electric conductivity.

4. The thermoelectric device of any of the preceding claims, wherein the first barrier region and the first semiconductor nanowire form an ohmic contact, and the second barrier region and the second semiconductor nanowire form an ohmic contact.

5. The thermoelectric device of any of the preceding claims, wherein a first conductive type of the first semiconductor nanowire is an N-type conductive type, and a second conductive type of the second semiconductor nanowire is a P-type conductive type.

6. The thermoelectric device of any of the preceding claims, wherein the first semiconductor nanowire and the second semiconductor nanowire comprise at least one of Si and Ge.

7. The thermoelectric device of claim 6, wherein the first barrier region or the second barrier region comprises at least one of a Si-metal compound, a Ge-metal compound, and a Si-Ge-metal compound.

8. The thermoelectric device of any of the preceding claims, wherein a first conductive type of the first semiconductor nanowire is an N-type conductive type, and a second conductive type of the second semiconductor nanowire is a P-type conductive type, and the first barrier region comprises erbium silicide, and the second barrier region comprises platinum silicide.

9. The thermoelectric device of any of the preceding claims, wherein the first electrode, the second electrode, and the common electrode comprise at least one of a doped semiconductor, a metal, and a metal compound.

10. The thermoelectric device of any of the preceding claims, wherein the common electrode comprises a first common electrode and a second common electrode, and the first common electrode comprises a material of the first electrode, and the second common electrode comprises a material of the second electrode.

11. The thermoelectric device of any of the preceding claims, wherein the first electrode, the second electrode, and the common electrode comprise at least one of a multi-layered structure including a semiconductor and a metal-silicide, a multi-layered structure including a semiconductor and a metal compound, and a multi-layered structure including a semiconductor and a metal.

12. The thermoelectric device of any of the preceding claims, wherein the first semiconductor nanowire and the first electrode form an ohmic contact, and the second semiconductor nanowire and the second electrode form an ohmic contact.

13. The thermoelectric device of claim 12, wherein the first semiconductor nanowire and the common electrode form an ohmic contact, and the second semiconductor nanowire and the common electrode form an ohmic contact.

14. A thermoelectric device module comprising:
a plurality of thermoelectric devices arranged in a first direction and a second direction crossing the first direction in a matrix structure;
first interconnection parts connecting the thermoelectric devices in series to constitute first groups; and
second interconnection parts connecting the first groups in parallel,
wherein each of the thermoelectric devices includes a first conductive type first semiconductor nanowire including at least one first barrier region, and a second conductive type second semiconductor nanowire including at least one second barrier region.

15. A method of forming a thermoelectric device, the method comprising:
providing a support substrate;
forming a first conductive type first semiconductor nanowire and a second conductive type second semiconductor nanowire on the support substrate, the nanowires being parallel with the support substrate;
forming at least one first barrier region in the first semiconductor nanowire;
forming at least one second barrier region in the second semiconductor nanowire; and
forming a first electrode connected to one end of the first semiconductor nanowire, a second electrode connected to one end of the second semiconductor nanowire, and a common electrode connected to the other end of the first semiconductor nanowire and the other end of the second semiconductor nanowire,
wherein the first barrier region is greater than the first semiconductor nanowire in thermal conductivity, and the second barrier region is greater than the second semiconductor nanowire in thermal conductivity.
